# FASCICULE DE BREVET EUROPEEN

(11) **EP 0 919 734 B1**
(45) Date de publication et mention de la délivrance du brevet: **06.10.2004**
(21) Numéro de dépôt: 98203910.9
(22) Date de dépôt: 18.11.1998
(51) Int. Cl.: F16B 21/07, B29C 65/58, H04M 1/03

(54) **Dispositif d'emboîtement pour la solidarisation de coques plastiques**
Steckverbindungssystem für Kunststoffschalen
Interlocking system for fastening plastics shells

(30) Priorité: 28.11.1997 FR 9715028
(43) Date de publication de la demande: 02.06.1999
(73) Titulaire: Koninklijke Philips Electronics N.V., 5621 BA Eindhoven (NL)
(72) Inventeur: Serre, Pascal, 75008 Paris (FR)
(74) Mandataire: Charpail, François

(56) Documents cités:
- EP-A- 0 337 227
- EP-A- 0 695 073
- DE-A- 19 639 197
- DE-U- 9 109 552
- FR-A- 2 328 430
- FR-A- 2 656 165
- GB-A- 1 441 640
- US-A- 4 324 549
- US-A- 4 634 004
- US-A- 4 726 705
- US-A- 5 363 079
- US-A- 5 536 917
- US-A- 5 561 588
- PATENT ABSTRACTS OF JAPAN vol. 017, no. 651 (M-1519), 3 décembre 1993 -& JP 05 209611 A (EIKO SHIODA), 20 août 1993
- PATENT ABSTRACTS OF JAPAN vol. 012, no. 195 (M-705), 7 juin 1988 -& JP 62 299625 A (MATSUSHITA ELECTRIC WORKS LTD), 26 décembre 1987
- PATENT ABSTRACTS OF JAPAN vol. 012, no. 332 (M-738), 8 septembre 1988 -& JP 63 095936 A (KASAI KOGYO CO LTD), 26 avril 1988

## Description

La présente invention concerne un dispositif d'emboîtement pour le verrouillage rigide de deux coques complémentaires dont au moins une première est en matière plastique moulée, comportant une partie femelle solidaire, par moulage commun, de ladite première coque et une partie mâle solidaire de la deuxième coque.

Depuis plusieurs décennies les boîtiers d'appareils électroniques, au moins en ce qui concerne les appareils de petite taille et de taille moyenne sont, le plus souvent, constitués par deux coques en matière plastique assemblées. A l'origine, l'assemblage s'effectuait essentiellement par vissage, en continuité avec ce qui se fait, habituellement, pour des boîtiers métalliques. Graduellement, des progrès ont été réalisés dans le moulage des coques en matière plastique et il est devenu possible de réaliser, au moins pour partie, l'assemblage de ces coques par clipage de parties emboîtables complémentaires dans l'une et l'autre coque, ces parties étant obtenues par moulage commun avec la coque support et leur emboîtement étant réalisé par pression, moyennant une déformation préalable permise par l'élasticité de la matière plastique.

Par appareil de taille moyenne on entend notamment des récepteurs de télévision, différents éléments d'un ensemble audio ou vidéo ou d'un ordinateur personnel, une base d'appareil téléphonique et par petit appareil, un calculateur de poche, un appareil de télécommande à rayonnement infrarouge et, plus récemment, un combiné de téléphone cellulaire ou de téléphone sans fil.

Le vissage des coques l'une contre l'autre procure l'avantage d'une bonne solidité d'assemblage et garantit contre la désolidarisation des coques lors d'un choc, dû à une chute notamment, ceci étant vrai surtout pour les petits appareils électroniques qui sont autonomes, étant munis d'une batterie, et que l'on peut tenir dans la main.

Par contre, la solidarisation par vissage présente aussi quelques inconvénients : elle implique la fourniture d'éléments séparés, c'est-à-dire des vis, et un temps d'assemblage assez long, directement proportionnel au nombre de vis prévues, le plus souvent supérieur à 4, d'où il résulte un coût d'assemblage assez élevé, et aussi un inconvénient moins apparent que les deux précédents mais parfois prépondérant, qui est la trop grande facilité de démontage, par un particulier notamment, ce qui peut annuler l'effet de la garantie de l'appareil en cas de panne.

Le bilan des avantages et inconvénients réciproques du vissage et du clipage résulte généralement en un compromis qui consiste à réaliser l'essentiel de la solidarisation par clipage tout en conservant au moins une vis pour achever cette solidarisation.

Le document FR-A- 2656165 montre un autre dispositif d'emboîtement destiné à être décroché de manière reversible par force de traction.

De nos jours, cependant, on souhaite pouvoir réaliser la solidarisation des coques entièrement par clipage, y compris pour de petits appareils qui, plus que les appareils de taille moyenne, sont susceptibles de chutes.

Avec un clipage de type classique tel que décrit par exemple dans le brevet US 5 536 917 en référence à la figure 1 de ce brevet particulièrement, chaque dispositif d'emboîtement destiné à remplacer une vis est constitué par une partie mâle sur une coque et une partie femelle sur l'autre coque, en dépendance assez étroite avec chaque coque support, et l'encliquetage réalisé est simple en ce sens qu'il sollicite une seule face de chaque emboîtement, lors de l'assemblage. Dans ces conditions, en cas de chute de l'appareil, les coques se tordent, dans des directions divergentes au point qu'elles entraînent dans leurs mouvements relatifs les parties d'emboîtement qu'elles comportent et qu'elles se désolidarisent. Les parties d'emboîtement peuvent aussi être cassées en conséquence du choc. En outre, les opérations de moulage des coques sont de plus en plus précises, permettant des épaisseurs faibles (de l'ordre de 2 mm), ce qui favorise leur déformation en cas de chocs. Pour remédier à cela, tout en conservant le type de clipage du type précité, on peut renforcer les dispositifs d'emboîtement en augmentant leurs dimensions, leur épaisseur particulièrement, et aussi leur nombre. Ceci réduit les risques de cassure et de déboîtement, lors d'une chute, mais ne résout pas le problème technique au point que le vissage puisse être entièrement supprimé et aussi, cela entraîne un nouveau problème pour les personnes qui doivent réaliser manuellement l'assemblage : le renforcement des dispositifs d'emboîtement requiert une pression d'autant plus élevée, pression qui devient inadmissible au-delà d'un certain seuil.

Un but de l'invention est de réaliser un assemblage rapide de deux coques plastiques formant boîtier d'un appareil électronique en s'affranchissant de tout ou partie d'assemblage par vis.

Un autre but de l'invention est de réaliser l'assemblage de deux coques plastiques au moyen de dispositifs d'emboîtement réalisés par moulage en même temps que les coques et de façon telle que ces coques ne se désolidarisent pas en cas de chute.

Encore un autre but de l'invention est de réaliser l'assemblage de deux coques plastiques entièrement au moyen de dispositifs d'emboîtement réalisés par moulage en même temps que les coques et de façon telle que les forces requises pour l'assemblage demeurent dans une plage de valeurs assez faibles.

Ces buts sont atteints et les inconvénients de l'art antérieur sont atténues grâce au dispositif d'emboîtement selon la revendication 1.

La symétrie ainsi conférée à chacune des deux parties de chaque dispositif d'emboîtement et leur conception indépendante des parois des coques empêche le déboîtement de ce dispositif d'emboîtement. En effet, si au cours d'un choc, les deux parties ont tendance à s'écarter d'un côté du dispositif d'emboîtement, l'effet de retenue est renforcé d'autant du côté opposé et la solidarisation est conservée après le choc. On notera que la fiabilité accrue pour l'accrochage des coques est importante pour de petits appareils qui sont destinés à tenir dans une main et donc plus exposés aux chutes que des appareils de taille moyenne. De plus, ces petits appareils, tels qu'un combiné de téléphone mobile, sont conçus pour résister aux chutes et doivent continuer à fonctionner même après plusieurs chutes. A plus forte raison, le boîtier de l'appareil ne doit pas se disloquer suite à un choc, même assez violent.

Ladite partie femelle se compose d'une pince à deux crochets symétriques par rapport à un plan de symétrie et que ladite partie mâle, qui s'étend dans ledit plan de symétrie perpendiculairement à la direction longitudinale desdits crochets, a une section dont la forme est constituée par un arc de cercle en ce qui concerne sa partie d'introduction et par deux méplats légèrement rentrants qui constituent ledit épaulement commun de la partie mâle en ce qui concerne sa partie opposée complémentaire à sa partie d'introduction.

Cette réalisation est intéressante plutôt pour de petits appareils car elle se prête bien à une miniaturisation. Par ailleurs les petits appareils, le plus souvent mobiles, comportent une batterie et il est commode d'implanter de tels dispositifs d'emboîtement dans une partie du volume occupé par la batterie, ce qui permet l'accès à ces emboîtements en vue de leur démontage éventuel.

Un autre mode de réalisation préféré de l'invention est remarquable en ce que ladite partie femelle est constituée par une douille sensiblement cylindrique comportant au moins trois crochets séparés par des fentes longitudinales, ledit premier espace formant un tronc de cône et ledit deuxième espace un cylindre et que la partie mâle est constituée par un téton à bout conique.

Cet autre mode de réalisation préféré de l'invention convient bien pour des appareils de taille moyenne où la miniaturisation n'est pas le souci premier. En outre, il permet un déverrouillage des dispositifs d'emboîtement depuis l'extérieur de l'appareil, et ceci au moyen d'un outil conçu à cet effet, qui ne fait pas partie de la présente invention.

On notera que, pour les deux modes de réalisation précités, la partie mâle du dispositif de liaison est massive et peu sujette à déformation. Ceci permet d'envisager la solidarisation de deux coques dont l'une, en matière plastique, en ABS de préférence, comporte les parties femelles des dispositifs d'emboîtement, et l'autre peut être métallique et comporter des parties mâles complémentaires en métal.

La description qui suit en regard des dessins annexés le tout donné à titre d'exemple fera bien comprendre comment l'invention peut être réalisée.

La figure 1 représente vu en plan et sans sa batterie le boîtier d'un combiné de téléphone sans fil qui incorpore un premier mode de réalisation de l'invention.

La figure 2 est la vue selon la coupe II-II de la figure 1.

La figure 3 est la vue agrandie d'une partie de la figure 2 qui incorpore l'invention.

La figure 4 représente en perspective un dispositif d'emboîtement selon un deuxième mode de réalisation de l'invention, avant emboîtement.

La figure 5 représente en A une vue en plan du dispositif de la figure 4, et en B et C les coupes B-B et C-C de la figure 5A.

La figure 6 est la coupe VI-VI de la figure 5A.

La figure 7 est une vue en perspective, avec arrachement, d'un dispositif semblable au dispositif de la figure 4 implanté sur deux coques à verrouiller.

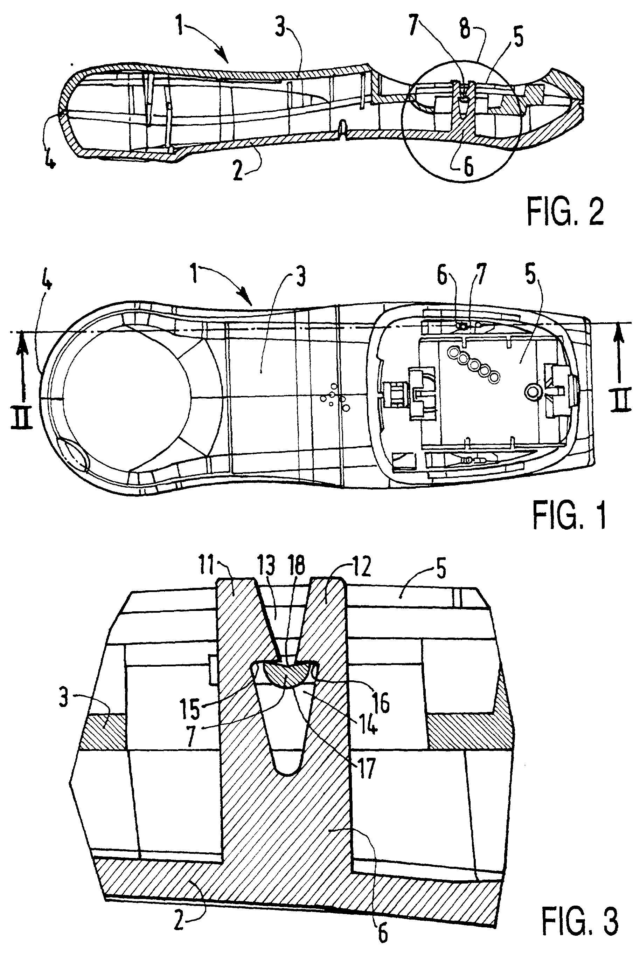

Les figures 1 et 2 représentent le boîtier 1 d'un combiné de téléphone sans fil (dit cordless en anglais), ce boîtier étant composé de deux coques assemblées, une coque dite coque avant 2 et une coque dite coque arrière 3, seule visible sur la figure 1. De façon connue, non représentée, pour le verrouillage des deux coques 2 et 3, il est prévu, à la partie dite haute 4 du combiné, intérieurement, des éléments de verrouillage rigide (non représentés) qui coopèrent, par encastrement à partir d'une position mutuelle des coques correspondant à une légère ouverture du boîtier vers le bas. Pour achever le verrouillage des coques à partir de cette position entrouverte, il est prévu des dispositifs d'emboîtement selon l'invention, visibles à la partie basse du boîtier 1 à l'endroit de la trappe de batterie de l'appareil qui sur les figures 1 et 2, correspond à un creux 5 pratiqué dans la coque arrière 3.

Ces dispositifs au nombre de deux sont situés latéralement et comportent chacun une partie femelle 6 solidaire de la coque avant 2 et une partie mâle 7 solidaire de la coque arrière 3. On notera que les parties 6 et 7 sont obtenues par moulage en même temps que leur coque respective, le produit de moulage utilisé étant de préférence du styrène-acrylonitrile-butadiène (ABS). A noter aussi que les parties mâle et femelle 6 et 7 ne sont pas solidaires directement des parois latérales de leur coque mais solidaires du fond de la coque, au moins en ce qui concerne la partie femelle 6.

Le dispositif d'emboîtement est mieux visible à la figure 3 qui est la partie 8 de la figure 2, agrandie à l'échelle 6. La partie femelle comporte deux crochets élastiques 11 et 12 disposés face à face symétriquement, ces crochets délimitant entre eux deux espaces, destinés à être sollicités successivement par la partie mâle 7 qui est en l'occurrence une poutre reliée par ses deux extrémités à la coque 3. Les deux espaces consistent en un premier espace d'introduction 13 de forme évasée, cet évasement ayant une forme en V ouvert à ses deux extrémités et un deuxième espace de retenue 14 dans lequel débouche l'espace d'introduction. A l'interface entre les espaces 13 et 14 sont présents deux crochets définis par leurs épaulements femelles 15 et 16. La partie mâle 7 comporte une exttémité d'introduction 17 qui va en s'élargissant du bas vers le haut, sur la figure 3, la taille de la partie 7 étant adaptée à celle de l'évasement 13 de façon à s'y encastrer dans un premier temps lors de son introduction en vue du verrouillage des coques. A sa partie supérieure, la partie mâle 7 se termine par un épaulement commun de partie mâle 18.

Plus précisément, le mode de réalisation de l'invention des figures 1 à 3 consiste en une pince à deux crochets symétriques 11 et 12. La partie mâle 7 en forme de poutre s'étend sensiblement dans le plan de symétrie des crochets 11 et 12, perpendiculairement à leur direction longitudinale et sa section est constituée, vers le bas, par un arc de cercle et vers le haut, par une corde reliée aux extrémités de cet arc de cercle et qui correspond à l'épaulement commun 18. De préférence, l'épaulement commun 18 est constitué par deux méplats légèrement rentrants avec une inclinaison de même sens que celle de l'espace 13, ce qui, lors du verrouillage par passage de la poutre 7 de l'espace 13 à l'espace 14, procure un meilleur effet anti-retour ou encore effet de harpon de cette partie 7 contre les épaulements 15 et 16, du fait que le contact de chaque méplat avec un épaulement 15, respectivement 16, se réduit à un point sur la section de la figure 3, au lieu d'un segment de droite, ce qui procure un meilleur accrochage entre les parties 6 et 7, en cas de choc notamment.

Pour les différents modes de réalisation de l'invention, il est prévu un démontage des coques. Pour le mode de réalisation des figures 1 à 3, on a indiqué plus haut que les dispositifs d'emboîtement étaient accessibles après enlèvement des batteries de l'appareil (du combiné). Pour désolidariser les parties 6 et 7, il suffit d'écarter les extrémités libres des crochets 11 et 12, soit à la main, soit au moyen d'un outil conçu à cet effet, de préférence. Au besoin, pour faciliter ce démontage, il est possible d'allonger, en forme de cornes, les extrémites libres des crochets 11 et 12.

La force nécessaire pour réaliser le verrouillage par fermeture des dispositifs d'emboîtement doit rester dans des limite raisonnables. Cette force est proportionnelle au nombre de ces dispositifs et aussi de la raideur des crochets 11 et 12 des parties femelles 6. On peut faire varier cette raideur en faisant varier la longueur utile des crochets, et/ou en variant leur épaisseur dans une direction perpendiculaire au plan des figures 2 et 3.

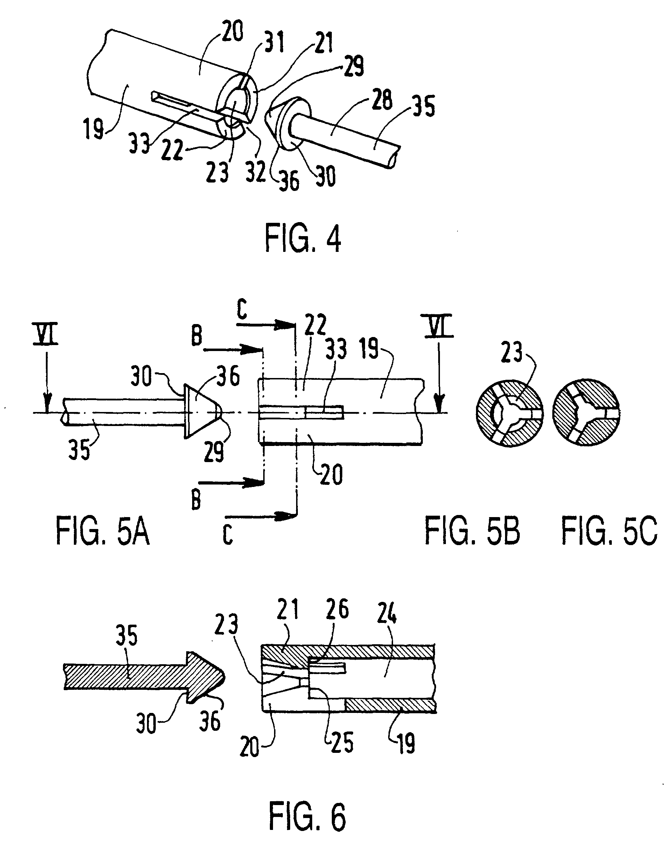

Un autre mode de réalisation du dispositif d'emboîtement selon l'invention, réservé de préférence à des appareils électroniques plus gros que des combinés téléphoniques, c'est-à-dire de taille moyenne, est représenté aux figures 4 à 7. On y retrouve les mêmes caractéristiques essentielles de l'invention, qui sont :
- pour la partie femelle 19, plusieurs crochets 20, 21, 22, un premier espace d'introduction 23 de forme évasée un deuxième espace de retenue 24 de section rectangulaire, et trois épaulements femelles 25, 26, 27 parmi lesquels les 25 et 26 sont visibles à la figure 6,
- pour la partie mâle 28, une extrémité d'introduction 29 proportionnée à l'espace d'introduction 23 qui s'élargit jusqu'à atteindre un épaulement commun de partie mâle 30.

Plus précisément, le mode de réalisation des figures 4 à 7 consiste en une douille cylindrique 19, comportant trois crochets 20, 21, 22 séparés par autant de fentes longitudinales 31, 32, 33. Le premier espace d'introduction 23 a la forme d'un tronc de cône et le deuxième espace de retenue 24 celle d'un cylindre. La partie mâle 28 est constituée par un téton 35 à bout conique 36.

La vue en plan de la figure 5A et les vues en coupe des figures 5B, 5C et 6 montrent certains détails du deuxième mode de réalisation de l'invention. Notamment (voir la figure 5) le bout conique 36 et le premier espace d'introduction 23 ont des petites bases qui ont sensiblement le même diamètre, alors que la grande base du bout 36 est plus grande que la grande base de l'espace 23, les deux troncs de cône 23 et 36 ayant par ailleurs des hauteurs sensiblement égales. D'autre part, selon une première variante, il est visible à la figure 6 que le grand diamètre du bout 36 est sensiblement égal au diamètre du deuxième espace de retenue 24. Ainsi, après emboîtement (non représenté) des parties 19 et 28, l'épaulement 30 appuie contre les épaulements 25, 26 et 27, il n'y a pas de jeu latéral, et les crochets 20, 21 et 22 ne sont pas, en l'absence de choc, sollicités radialement vers l'extérieur. Comme pour le premier mode de réalisation des figures 1 à 3, il peut être avantageux de réaliser l'épaulement 30 légèrement rentrant de façon à améliorer l'accrochage de cet épaulement mâle contre les épaulements femelle 25, 26, 27. On notera aussi que la raideur des crochets 20, 21 et 22 est favorisée par leur forme courbe qui procure un effet de nervure. Comme pour le premier mode de réalisation, cette raideur peut être modifiée en faisant varier la longueur des crochets et/ou le diamètre de la douille 19, à épaisseur dans le sens radial constante, la raideur étant d'autant moins prononcée que cette longueur est grande et/ou que ce diamètre est petit.

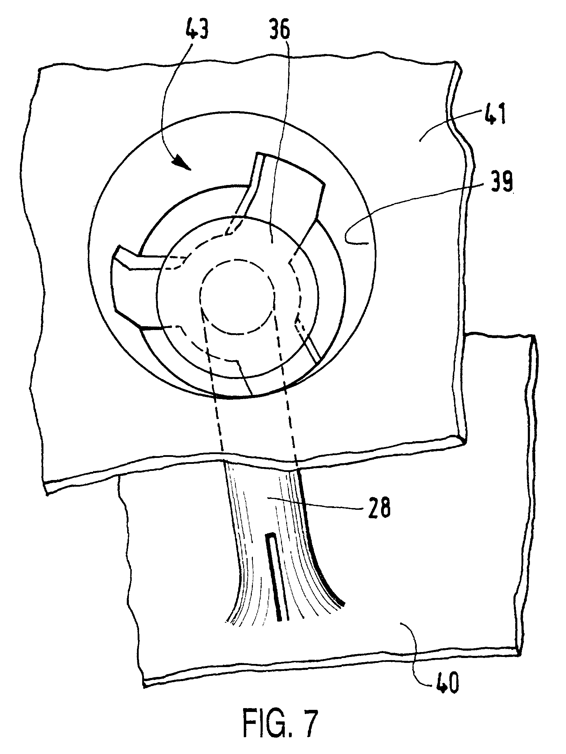

La figure 7 représente une autre variante du deuxième mode de réalisation de l'invention, où l'on voit les parties 28 mâle et 39 femelle du dispositif reliées à leurs coques respectives 40 et 41, après emboîtement. On notera, sur cette figure, que le deuxième espace, 43, débouche sur l'extérieur de la première coque 41. Par ailleurs, ce deuxième espace est de forme tronconique, s'élargissant vers l'extérieur, une dépouille de quelques degrés étant nécessaire pour le moulage commun de la douille 39 avec sa coque support 41. Cette forme tronconique peut être mise à profit pour le démontage du dispositif au moyen d'un outil approprié. Un tel outil de forme comparable à celle de la partie mâle 28 mais plus grosse que cette dernière agit, par enfoncement à travers le deuxième espace 43 de façon à écarter progressivement les extrémités des crochets de la partie femelle 39, jusqu'à libération du bout conique 36, extrémité de la partie mâle 28 que la tête de l'outil peut continuer à repousser hors de la douille pour désassemblage complet.

Pour le mode de réalisation de la figure 7, l'élément mâle 28 et la coque 40 sont généralement en matière plastique, en ABS et sont obtenus par moulage commun de préférence. Cependant, la partie mâle 28 pourrait être conçue comme un élément séparé en métal et être solidarisée par sa base, par tout moyen connu, à une coque en matière plastique ou en métal. Cette dernière variante permet par exemple de fixer un enjoliveur à un moyeu de roue d'automobile.

L'invention permet de diminuer le nombre de vis pour la solidarisation de deux coques et même de supprimer totalement la visserie à cet effet, surtout en ce qui concerne le deuxième mode de réalisation qui permet un accès facile depuis l'extérieur en vue du démontage des coques.

## Revendications

1. Dispositif d'emboîtement incluant une partie femelle (6) présentant au moins deux crochets disposés face à face symétriquement de façon à délimiter entre eux longitudinalement un espace d'introduction (13) de forme évasée, ledit évasement ayant son grand diamètre à l'extrémité libre, et un espace de retenue (14) de section longitudinale rectangulaire, l'interface entre lesdits espace d'introduction et de retenue formant au moins deux épaulements femelles (15, 16), une partie male (7) destiné à être emboîté dans la partie femelle (6) par sollicitation des espaces d'introduction et de retenue, ladite partie male (7) incluant une extrémité d'introduction (17), **caractérisé en ce que** lesdits épaulements femelles (15, 16) sont légèrement inclinés selon une inclinaison de même sens que celle dudit espace d'introduction (13), ladite extrémité d'introduction de ladite partie male étant de diamètre légèrement inférieur au grand diamètre dudit évasement puis s'élargissant jusqu'à atteindre un épaulement commun (18) de partie male (7), ledit épaulement commun (18) de partie male (7) étant incliné selon le même sens d'inclinaison que lesdits épaulements femelles (15,16) de manière à ce que le contact entre lesdits épaulements femelles (15, 16) et ledit épaulement commun (18) de partie male (7) soit réduit à un point quand l'extrémité d'introduction (17) est introduite dans ledit espace de retenue (14).

2. Dispositif d'emboîtement selon la revendication 1, **caractérisé en ce que** ladite partie femelle (6) se compose d'une pince à deux crochets (11, 12) symétriques par rapport à un plan de symétrie et que ladite partie mâle (7), qui s'étend dans ledit plan de symétrie perpendiculairement à la direction longitudinale desdits crochets, a une section dont la forme est constituée par un arc de cercle en ce qui concerne sa partie d'introduction (17) et par deux méplats légèrement rentrants qui constituent ledit épaulement commun (18) de la partie mâle en ce qui concerne sa partie opposée complémentaire à sa partie d'introduction (17).

3. Coques (2, 3) pour combiné de téléphone cellulaire ou de téléphone sans fil ou pour appareil de télécommande à rayonnement infrarouge, **caractérisées en ce qu'**elles comportent au moins deux dispositifs d'emboîtement (6-7) selon la revendication 2, accessibles en dessous de la batterie amovible dudit combiné ou appareil de télécommande.

4. Dispositif d'emboîtement selon la revendication 1, **caractérisé en ce que** ladite partie femelle est constituée par une douille (19) sensiblement cylindrique comportant au moins trois crochets (20, 21, 22) séparés par des fentes longitudinales (31, 32, 33), ledit premier espace (23) formant un tronc de cône et ledit deuxième espace (24) un cylindre et que la partie mâle (28) est constituée par un téton (35) à bout conique (36).

5. Dispositif d'emboîtement selon la revendication 4, **caractérisé en ce que** ledit deuxième espace (43) de la partie femelle (39) débouche sur l'extérieur de ladite première coque (41).

6. Coques (40, 41) pour appareil électronique tel qu'une base de téléphone sans fil, un récepteur de télévision, un ordinateur personnel ou autre élément d'ensemble audio ou vidéo, comportant au moins deux dispositifs d'emboîtement (28-39) selon la revendication 5.

7. Dispositif d'emboîtement (6-7, 28-39) selon l'une des revendications 1, 2, 4, 5, **caractérisé en ce que** ladite partie mâle (7, 28) est métallique.

## Patentansprüche

1. Steckverbindungssystem mit einem weiblichen Teil (6) mit mindestens zwei symmetrisch gegenüberliegend angeordneten Haken, um längs zwischen sich einen Einführungsraum (13) ausgehöhlter Form zu bilden, wobei die besagte Aushöhlung ihren großen Durchmesser am freien Ende hat, und mit einem Rückhalteraum (14) rechteckigen länglichen Schnitts, wobei die Schnittstelle zwischen dem besagten Einfuhrungsraum und dem Rückhalteraum mindestens zwei weibliche Schultern bildet (15, 16), ein männlicher Teil (7) dafür bestimmt ist, in den weiblichen Teil (6) durch Beanspruchung des Einführungsraums und des Rückhalteraums eingesteckt zu werden, wobei der männliche Teil (7) ein Einführungsende (17) aufweist, **dadurch gekennzeichnet, dass** die weiblichen Schultern (15, 16) leicht in derselben Neigungsrichtung wie die des besagten Einführungsraums (13) geneigt sind, das besagte Einführungsende des besagten männlichen Teils einen leicht kleineren Durchmesser als der große Durchmesser der besagten Aushöhlung hat, der sich im Verlauf zur gemeinsamen Schulter (18) des männlichen Teils (7) verbreitert, die besagte gemeinsame Schulter (18) des männlichen Teils (7) in derselben Neigungsrichtung wie die besagten weiblichen Schultern (15,16) geneigt ist, damit der Kontakt zwischen den besagten weiblichen Schultern (15, 16) und der besagten gemeinsamen Schulter (18) des männlichen Teils (7) sich auf einen Punkt reduziert, wenn das Einführungsende (17) in den besagten Rückhalteraum (14) eingeführt ist.

2. Steckverbindungssystem nach Anspruch 1, **dadurch gekennzeichnet, dass** der besagte weibliche Teil (6) sich aus einer Klammer mit zwei in Bezug auf eine symmetrische Fläche symmetrischen Haken (11, 12) zusammensetzt, und der besagte männliche Teil (7), der sich auf der besagten symmetrischen Fläche rechtwinklig in Längsrichtung zu den besagten Haken erstreckt, einen Querschnitt hat, dessen Form in Bezug auf seinen einzuführenden Teil (17) von einem Kreisbogen gebildet wird, und aus zwei leicht einrückenden Anflachungen, die die besagte gemeinsame Schulter (18) des männlichen Teils in Bezug auf sein entgegengesetztes, zum Einführungsteil ergänzendes Teil (17) bildet.

3. Schalen (2, 3) für Funktelefongerät oder schnurloses Telefon oder Infrarot-Fernbedienung, **dadurch gekennzeichnet, dass** sie mindestens zwei Steckverbindungssysteme (6-7) nach Anspruch 2 aufweisen, die unterhalb des herausnehmbaren Akkumulators des besagten Telefongeräts oder der besagten Fernbedienung zugänglich sind.

4. Steckverbindungssystem nach Anspruch 1, **dadurch gekennzeichnet, dass** der weibliche Teil aus einer weitgehend zylindrischen Hülse (19) mit mindestens drei durch längliche Schlitze (31, 32, 33) getrennten Haken (20, 21, 22) gebildet wird, wobei der besagte erste Raum (23) einen Kegelstumpf und der besagte zweite Raum (24) einen Zylinder bildet und der männliche Teil (28) aus einem Nippel (35) mit konischer Spitze (36) gebildet wird.

5. Steckverbindungssystem nach Anspruch 4, **dadurch gekennzeichnet, dass** der besagte zweite Raum (43) des weiblichen Teils (39) nach außen zur besagten ersten Schale (41) führt.

6. Schalen (40, 41) für elektronisches Gerät wie ein Basisteil eines schnurlosen Telefons, ein Fernsehempfänger, ein Personalcomputer oder ein Element eines Audio- oder Videosystems mit mindestens zwei Verbindungsvorrichtungen (28-39) nach Anspruch 5.

7. Steckverbindungssystem (6-7, 28-39) nach einem der Ansprüche 1, 2, 4, 5, **dadurch gekennzeichnet, dass** das besagte männliche Teil (7, 28) metallen ist.

## Claims

1. An interlocking device including a female part (6) having at least two hooks symmetrically facing each other so as to define lengthwise between them a flared insertion space (13), the flared space having its large diameter at the free end, and a holding space (14) of rectangular longitudinal section, the interface between said holding and insertion spaces forming at least two female shoulders (15, 16), a male part (7) intended to be locked in the female part (6) by the touch of the insertion and holding spaces, said male part (7) including an insertion tip (17), **characterized in that** said female shoulders (15, 16) are slightly inclined at an angle in the same direction as that of said insertion space (13), said insertion tip of said main part being of a slightly smaller diameter than the large diameter of said flare then becoming larger as it reaches a common shoulder (18) of the male part (7), said common shoulder (18) of the male part (7) being at an angle in accordance with the same inclination as said female shoulders (15, 16) in a way that the contact between said female shoulders (15, 16) and the common shoulder (18) of the male part (7) is reduced to a point where the insertion tip (17) is inserted in said retaining space (14).

2. An interlocking device as claimed in claim 1, **characterized in that** said female part (6) is formed by a clip having two symmetrical hooks (11, 12) relative to a plane of symmetry and **in that** said male part (7), which stretches out in said plane of symmetry perpendicularly to the longitudinal direction of said hooks, has a section whose form is constituted by an arc of circle as regrads its inserting part (17) and by two slightly detractable flat surfaces which form said common shoulder (18) of the male part as regards its opposite part which is complementary to its inserting part (17).

3. Shell halves (2, 3) for a cellular or cordless telephone handset or for an infrared remote control, **characterized in that** they comprise at least two interlocking devices (6-7) in accordance with claim 2, accessible underneath the removable battery of said handset or remote control.

4. An interlocking device as claimed in claim 1, **characterized in that** said female part is formed by a substantially cylindrical sleeve (19) and comprises at least three hooks (20, 21, 22) separated by longitudinal grooves (31, 32, 33), said first space (23) forming a truncate cone and said second space (24) a cylinder and **in that** the male part (28) is formed by a lug (35) with a cone-shaped end (36).

5. An interlocking device as claimed in claim 4, **characterized in that** said second space (43) of the female part (39) becomes wider towards the exterior of said first shell half (41).

6. Shell halves (40, 41) for an electronic device such as a cordless telephone base station, a television receiver, a personal computer or other elements of an audio or video set, comprising at least two interlocking devices (28-39) as claimed in claim 5.

7. An interlocking device (6-7, 28-39) as claimed in one of the claims 1,2,4, 5, **characterized in that** said male part (7, 28) is a metal element.
